# EUROPEAN PATENT APPLICATION

(11) **EP 4 759 447 A1**
(43) Date of publication of application: **17.06.2026**
(21) Application number: 25751347.3
(22) Date of filing: 24.01.2025
(51) Int. Cl.: B08B 5/02, B08B 5/04, B08B 5/00, B23Q 11/00, H01L 21/02, H01L 21/67, H01L 21/00

(54) **WAFER PROCESSING CLEANING DEVICE**

(30) Priority: 10.01.2025 CN 202510045867
(71) Applicant: Dongguan Villo Technology Inc., Dongguan, Guangdong 523000 (CN)
(72) Inventor: WANG, Yinan, Dongguan, Guangdong 523000 (CN); LI, Haiyan, Dongguan, Guangdong 523000 (CN); CHU, Shiyun, Dongguan, Guangdong 523000 (CN); LI, Huaijun, Dongguan, Guangdong 523000 (CN); XU, Wenqi, Dongguan, Guangdong 523000 (CN); YAO, Xing, Dongguan, Guangdong 523000 (CN); CAI, Junwei, Dongguan, Guangdong 523000 (CN); YUAN, Weijie, Dongguan, Guangdong 523000 (CN); ZHANG, Kewei, Dongguan, Guangdong 523000 (CN); HUANG, Wenbin, Dongguan, Guangdong 523000 (CN); CHI, Haopeng, Dongguan, Guangdong 523000 (CN); CHEN, Xiaochen, Dongguan, Guangdong 523000 (CN)
(74) Representative: Plavsa, Olga
(86) International application number: PCT/CN2025/074773
(87) International publication number: WO 2025/167745

(57) **Abstract**

A cleaning device for wafer processing, comprising a bottom frame (11), wherein uprights columns (12) extending upwards are provided at the four corners of the bottom frame (11); an upper frame (13) is provided on the ends of the uprights columns (12) away from the bottom frame (11); the bottom frame (11), the uprights columns (12) and the upper frame (13) constitute a mounting frame; a mounting plate (14) is provided in the mounting frame; a moving mechanism (21) is mounted on the mounting plate (14); a dust removal mechanism (41) is provided below the moving mechanism (21); an air pressure assembly (61) is provided above the moving mechanism (21); the dust removal mechanism (41) is connected to the air pressure assembly (61) by means of a duct (59); the dust removal mechanism (41), the moving mechanism (21) and the air pressure assembly (61) are arranged in the mounting frame; the dust removal mechanism (41) is connected to the moving mechanism (21) by means of a slidable second hanging slide carriage (34), and the dust removal mechanism (41) comprises a dust removal head box (42); a bottom plate (49) is provided at the bottom of the dust removal head box (42); an opening is provided in the top of the dust removal head box (42); a box sealing cover (48) is provided at the opening in the top end of the dust removal head box (42); and a positive pressure box (44), which extends upwards from the bottom plate (49), is provided in the dust removal head box (42). The cleaning device for wafer processing uses two fans to provide positive or negative pressure air sources, thereby realizing intelligent cleaning.

## Description

### TECHNICAL FIELD

The present invention relates to the technical field of semiconductor production and, in particular, to a cleaning device for wafer processing.

### BACKGROUND OF THE INVENTION

A wafer is a silicon chip used in the manufacturing of silicon semiconductor integrated circuits. The wafer is applied to production of integrated circuit chips. In the process of semiconductor production, wafers are placed in wafer cassettes, and the wafer cassettes are transported to the carriers of different Loadports through an Automated Material Handling System (AMHS). After a period of time, dust will remain on the surface of the carriers, which affects the yield of wafer products.

To maintain the cleanliness of the carriers, the carriers of semiconductor processing equipment need to be cleaned regularly. Known cleaning methods mostly include manual cleaning and brush cleaning. Manual cleaning can only be carried out during equipment maintenance, which is time-consuming, labor-intensive and inefficient; it is also unfavorable to the overall working environment and there is no way to control the cleanliness. Brush cleaning is a contact-type method, which has the risks of scratching the carriers and generating static electricity.

### BRIEF SUMMARY OF THE INVENTION

To address the problems existing in the prior art, an objective of the present invention is to provide a cleaning device for wafer processing, which adopts non-contact suspended positive and negative air path cleaning. Moreover, the cleaning device achieves air-electricity isolation and independent operation, thereby improving the stability of product processing and product yield.

In order to achieve the above objective, the present invention adopts the following technical solutions:
A cleaning device for wafer processing includes a bottom frame; upright columns extending vertically upwards are provided at four corners of the bottom frame; an upper frame is provided at one ends of the upright columns away from the bottom frame; the bottom frame, the upright columns and the upper frame form a mounting frame; a mounting plate is provided in the mounting frame; a moving mechanism is mounted on the mounting plate; a dust removal mechanism is arranged below the moving mechanism, and an air pressure assembly is arranged above the moving mechanism; the dust removal mechanism is connected to the air pressure assembly by means of a duct; the dust removal mechanism, the moving mechanism and the air pressure assembly are arranged in the mounting frame;
the dust removal mechanism is connected to the moving mechanism by means of a second hanging slide carriage; the dust removal mechanism includes a dust removal head box; a bottom plate is arranged at the bottom of the dust removal head box, an opening is arranged at the top of the dust removal head box, and a box sealing cover is arranged at the opening at the top end of the dust removal head box; a positive pressure box extending upward from the bottom plate is arranged inside the dust removal head box, and a separation distance is provided between the top end of the positive pressure box and the top end of the dust removal head box;
a separation distance is provided between an outer wall of the positive pressure box and an inner wall of the dust removal head box; a negative pressure cavity is arranged outside the positive pressure box, and the negative pressure cavity is arranged between the inner wall of the dust removal head box and the outer wall of the positive pressure box;
the moving mechanism includes a first mounting slide rail and a first rack seat; the first rack seat and the first mounting slide rail are fixedly arranged below the mounting plate, and the first mounting slide rail and the first rack seat are arranged on a side of the mounting plate away from the upright posts; the first rack seat and the first mounting slide rail are arranged parallel to the mounting plate;
a slidable first hanging slide carriage is hung on the first mounting slide rail, a first motor is fixedly arranged on the first hanging slide carriage, and the first motor is in meshing transmission connection with the first rack seat.

Further, in some embodiments, a positive pressure sealing cover is arranged at an end of the positive pressure box away from the bottom plate, an air intake cylinder extending upward and penetrating a box sealing cover is arranged on the positive pressure sealing cover, an end of the air intake cylinder away from the positive pressure box protrudes above the box sealing cover, an upper end of the air intake cylinder is connected to a duct, and the air intake cylinder is in through connection with the positive pressure box;
an air suction port is provided on the box sealing cover and is in through connection with the negative pressure cavity; the positive pressure box and the negative pressure cavity are respectively arranged in the dust removal head box, and are isolated from each other and not connected with each other;
a first dust blowing slot transversely penetrating the bottom plate is arranged at the bottom of the positive pressure box; matching and symmetrical second dust blowing slots are arranged at ends of the bottom of the positive pressure box close to two ends of the first dust blowing slot; a side blowing distance is provided between each second dust blowing slot and the top end of the first dust blowing slot; the second dust blowing slots are arranged perpendicular to the first dust blowing slot and in connection with the first dust blowing slot;
a height ratio of the positive pressure box to the dust removal head box is 2/3-3/4:1.

Further, in some embodiments, an air pressure assembly base is arranged below the first hanging slide carriage and is fixedly connected to the first hanging slide carriage; the air pressure assembly base is arranged perpendicular to the first mounting slide rail, with one end of the air pressure assembly base extending out of the mounting plate; a bearing wheel is arranged at an end of the air pressure assembly base away from the mounting plate, and the bearing wheel is arranged on a support crossbeam which is arranged between two adjacent upright columns;
a second mounting slide rail and a second rack seat, which are parallel to each other, are fixedly arranged on a side of the air pressure assembly base away from the first hanging slide carriage, and the second mounting slide rail and second rack seat which are parallel to each other are arranged perpendicular to the first mounting slide rail;
a slidable second hanging slide carriage is hung on the second mounting slide rail, a second motor is arranged on the second hanging slide carriage, and the second motor is in meshing transmission connection with the second rack seat;
the air pressure assembly is arranged on one side of the air pressure assembly base away from the mounting plate; the air pressure assembly is arranged outside the mounting plate;
the air pressure assembly includes a negative pressure fan and a positive pressure fan; a negative pressure high-efficiency filter chamber is arranged above the negative pressure fan, and an air suction port of the negative pressure high-efficiency filter chamber extends laterally to the outside of the negative pressure fan;
the air suction port of the negative pressure high-efficiency filter chamber is in conductive connection with an air suction port of the dust removal mechanism by means of a duct; the positive pressure fan is in conductive connection with the air intake cylinder of the dust removal mechanism by means of another duct.

Further, in some embodiments, a muffler box is arranged on one side of the negative pressure fan, and an air outlet of the negative pressure fan is connected to the muffler box by means of a duct;
a square honeycomb cylinder is arranged in the muffler box; a plurality of through holes are arranged in a frame square cylinder plate surface of the square honeycomb cylinder, and staggered oblique honeycomb baffles on left and right sides are arranged in the square honeycomb cylinder;
the oblique honeycomb baffles extend obliquely upward from inner side walls of the square honeycomb cylinder; the oblique honeycomb baffles on two sides are arranged one above the other in a staggered manner; the oblique honeycomb baffles on two sides are staggered, and the top ends of the oblique honeycomb baffles on two sides overlap with each other vertically; the staggered oblique honeycomb baffles on the two sides form an S-shaped air channel inside the square honeycomb cylinder;
the negative pressure fan is provided with a lateral air outlet, which is connected to the muffler box by means of a duct.

Further, in some embodiments, first suction slots and second suction slot, which transversely penetrate the bottom plate, are arranged at the bottom of the negative pressure cavity, and the first suction slots and the second suction slots are arranged parallel to the first dust blowing slot; the first suction slots are arranged close to the first dust blowing slot, the second suction slots are arranged away from the first dust blowing slot, and a separation distance is provided between each first suction slot and a corresponding second suction slot;
two matching and corresponding variable-section rods are arranged on a positive pressure cavity bottom of the positive pressure box, the variable-section rods are arranged parallel to the first dust blowing slot, and the two variable-section rods are arranged on two sides of the first dust blowing slot respectively;
the variable-section rods are provided with compressed airflow convex bosses protruding inward; an air intake distance D1 is provided between the tops of the two matching and corresponding variable-section rods, a convex boss distance D2 is provided between the compressed airflow convex bosses 19 on two opposite sides of the middle parts of the two variable-section rods, and the air intake distance D1 is greater than the convex boss distance D2; an air output distance D3 is provided between the bottoms of the two matching and corresponding variable-section rods, and the first dust blowing slot arranged on the positive pressure cavity bottom is provided with a dust blowing distance D4 which is also the width of the first dust blowing slot; the air intake distance D1 is equal to the air output distance D3, and the air output distance D3 is greater than the dust blowing distance D4.

Further, in some embodiments, the compressed airflow convex bosses are each in the shape of a convex strip; or the compressed airflow convex bosses are elongated strips with an arc-shaped cross-section; or the compressed airflow convex bosses are elongated strips with a short chord-shaped cross-section;
a ratio of the air intake distance D1 to the convex boss distance D2 is 5-10:1;
the air intake distance D1 is equal to the air output distance D3; a ratio of the dust blowing distance D4 to the convex boss distance D2 is 1:1-1.5;
third suction slots longitudinally penetrating the bottom plate are arranged at the bottom of the negative pressure cavity on two short sides; the third suction slots are arranged between outer walls of the positive pressure box on two short sides and an inner wall of the dust removal head box, and the third suction slots are arranged parallel to the second dust blowing slots;
the second dust blowing slots are arranged close to inner walls of the positive pressure box on the two short sides;
a width ratio of the first dust blowing slot to the first suction slot to the second suction slot is 1:4-5:4-5;
a width ratio of the second dust blowing slot to the third suction slot is 1:4-5;
an air volume ratio of the first dust blowing slot to the first suction slot is 1:1.5-3; the air volume of the second suction slot is equal to that of the first suction slot;
an air volume ratio of the second dust blowing slot to the third suction slot is 1:1.5-3.

Further, in some embodiments, the mounting plate is arranged at the middle part of the mounting frame; the mounting plate is connected to two adjacent upright columns on one side, and connected to the upper frame on the other side by means of a vertical plate; a vertical frame is arranged between one end of the mounting plate close to the upright columns and the bottom frame, and a support crossbeam is arranged between the two upright columns away from the mounting plate;
the air pressure assembly is arranged above the moving mechanism, the dust removal mechanism is connected to the air pressure assembly by means of a duct, and the dust removal mechanism, the moving mechanism and the air pressure assembly are arranged in the mounting frame; the box sealing cover is connected to the moving mechanism by means of the second hanging slide carriage.

Further, in some embodiments, the mounting plate is arranged at the middle part of the mounting frame; one end of the mounting plate is fixedly arranged at the middle parts of two adjacent upright columns, and the other end of the mounting plate away from the upright columns is connected to the upper frame by means of a vertical plate; a vertical frame is arranged between one end of the mounting plate close to the upright columns and the bottom frame, and a support crossbeam is arranged between the two upright columns away from the mounting plate;
a gear on an output shaft of the first motor is in meshing transmission connection with the first rack seat; a gear on an output shaft of the second motor is in meshing transmission connection with the second rack seat;
the dust removal mechanism is hung at an end of the second hanging slide carriage away from the second mounting slide rail.

The present application adopts a non-contact dust removal head for cleaning and employs an automated cleaning device. The cleaning device of the present application is adapted to the size of chip cassettes (boxes for holding chip wafers) on a carrier and used for cleaning the carrier. The device of the present application is placed on a chip carrier to perform cleaning. In a working environment, there are generally hundreds or thousands of wafer processing carriers (stations). A crown block system is configured in the working environment, and a mobile fixture is mounted on a crown block. After the cleaning of one station is completed, the crown block system transports the cleaning device of the present application to the next available station to be cleaned (carrier station). With only the station route map as a guide, the cleaning device can reach each available station to clean the available stations one by one.

The present application adopts a non-contact suspension and air-electric isolation design. A dust removal working space is enclosed through fluctuating airflow dust blowing → air curtain isolation (negative pressure suction); a high-efficiency filter is arranged on a suction fan (negative pressure fan) to perform (high-efficiency) filtration on dust. Two fans provide positive-pressure or negative-pressure air sources without the need for an external air source; in addition, a battery is adopted for power supply without the need for an external power supply. Both the fans and motors operate at 24 V, and the entire device is isolated from external air and electrical connections. The two fans are arranged on the mounting rails (translation guide rails) and are movable. The fans are connected to the dust removal head by means of air ducts and move together with the dust removal head. When the dust removal head (dust removal assembly) moves, the fans move together with the dust removal head. In this way, the distance between the fans and the dust removal head will not increase too much, which helps avoid collisions with adjacent plates and shafts, and achieves intelligent cleaning.

The dust removal head (blowing and suction head) of the present application performs blowing, sweeping and cleaning by means of the central dust blowing slot and suction by means of the surrounding suction slots. The dust removal head is suspended above the carrier without contact. The design of a central dust blowing slot for blowing and surrounding suction slots for suction prevents dust from escaping outward; the negative-pressure suction at the surrounding (suction slots) prevent air leakage and dust escape.

Two suction slots (narrow suction channels) are provided on each side of the dust removal head, and the width of the suction slots is greater than that of the dust blowing slots. The air blown downward from the central dust blowing slot of the dust removal head (working gun) spread to two sides. Two suction-slot air curtains are arranged on each of two sides to suck away the dust. Additional dust blowing slots and suction slots are provided on the narrow sides of the dust removal head at two ends, and the surrounding suction slots form a suction air curtain. This design prevents dust from spreading out of the blowing gun, improves cleaning efficiency, and enhances the automation level of the device.

### BRIEF DESCRIPTION OF THE SEVERAL VIEWS OF THE DRAWINGS

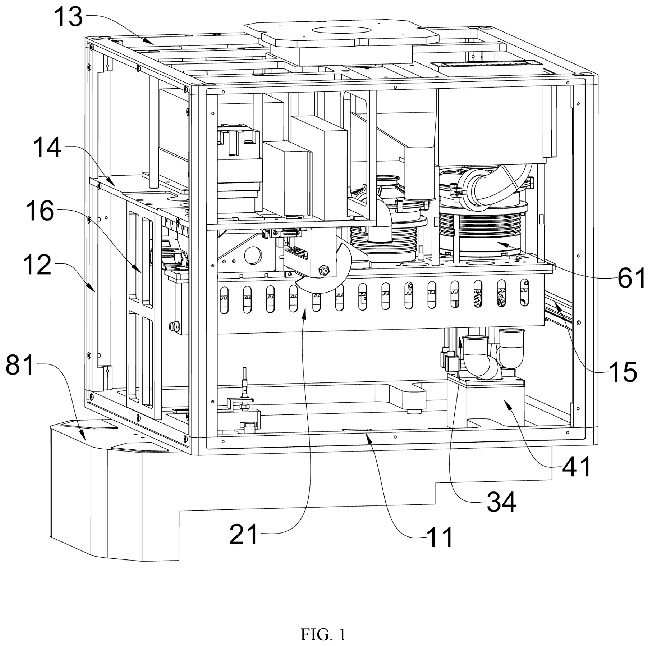

FIG. 1 is a schematic application diagram of an embodiment of the present invention.

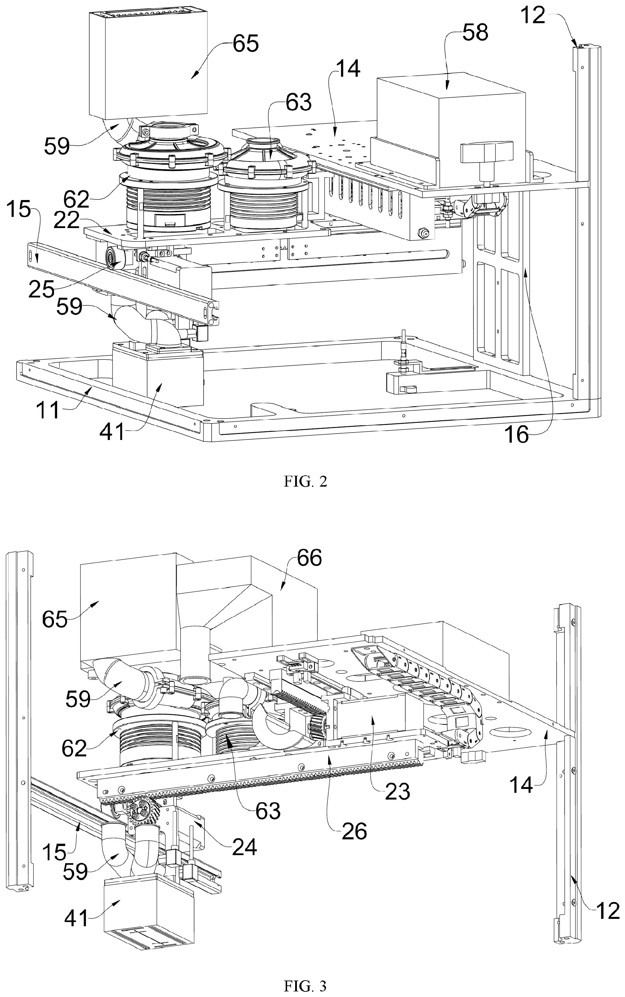

FIG. 2 is a schematic structural diagram of an embodiment of the present invention.
FIG. 3 is a perspective schematic diagram of an embodiment of the present invention.

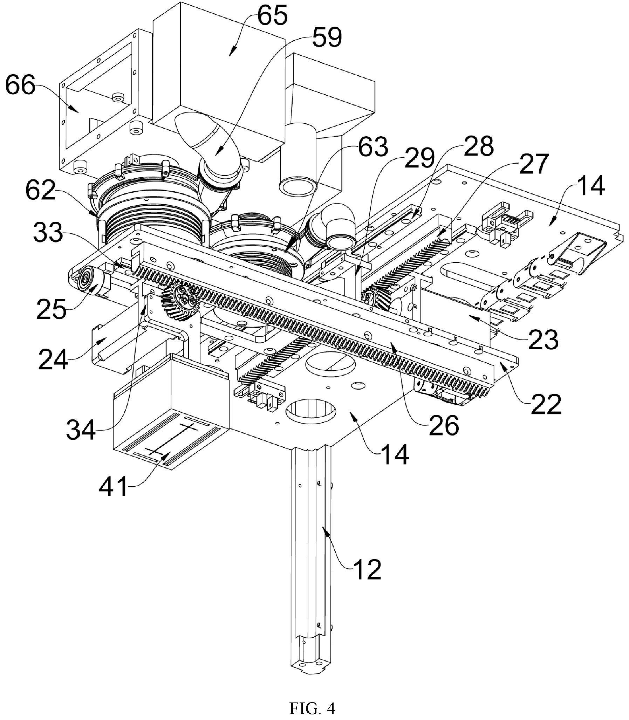

FIG. 4 is a top schematic diagram of an embodiment of the present invention.

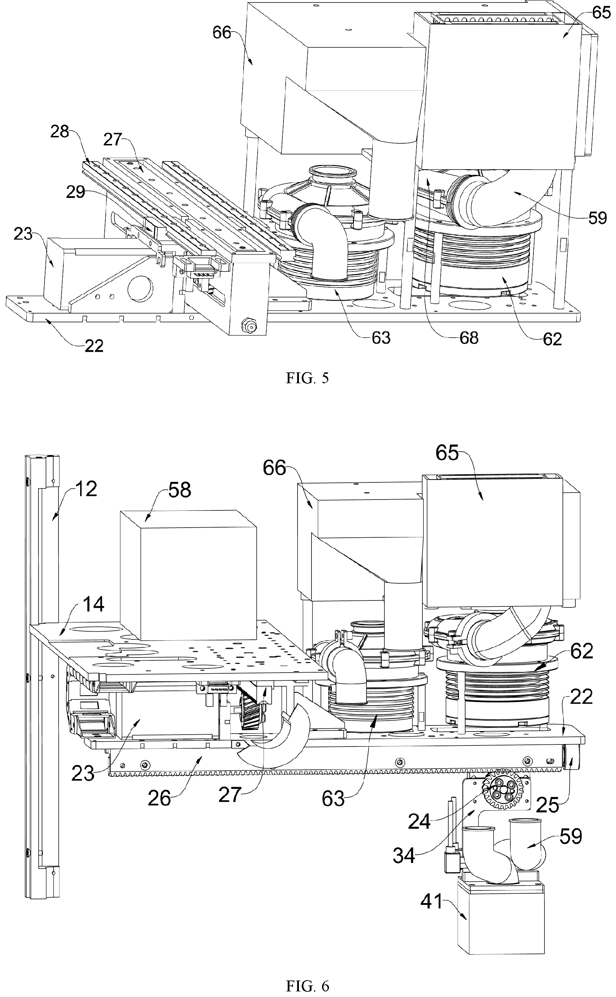

FIG. 5 is a schematic structural diagram of an air pressure assembly part in an embodiment of the present invention.
FIG. 6 is a schematic structural diagram of an air pressure assembly base part in an embodiment of the present invention.

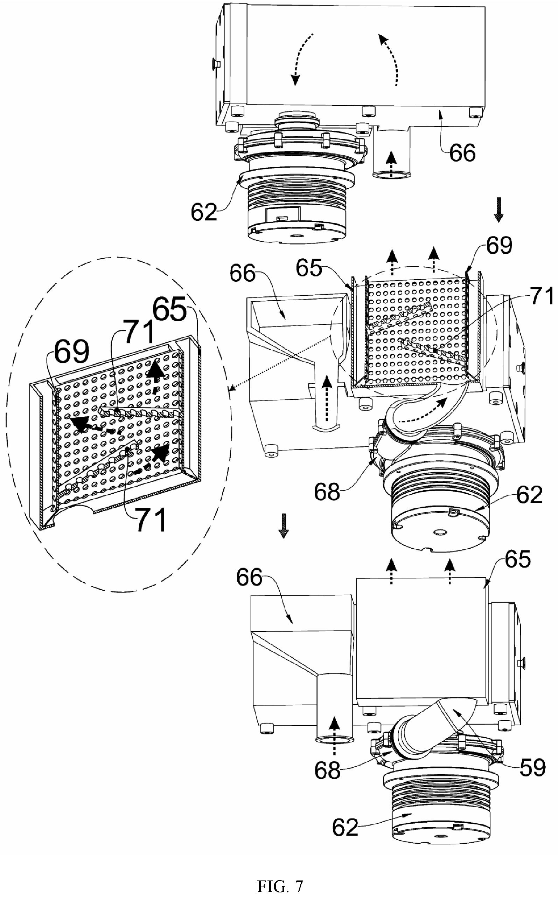

FIG. 7 is a schematic structural diagram of a negative pressure fan part in an embodiment of the present invention.

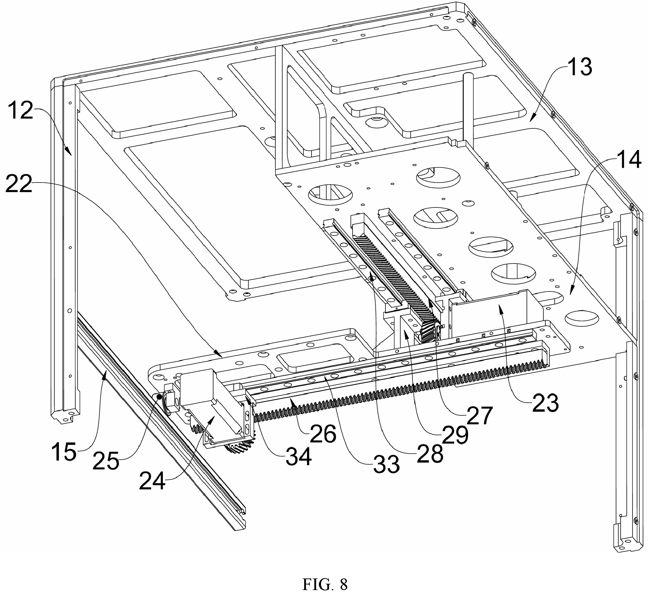

FIG. 8 is a schematic structural diagram of a moving mechanism part in an embodiment of the present invention.

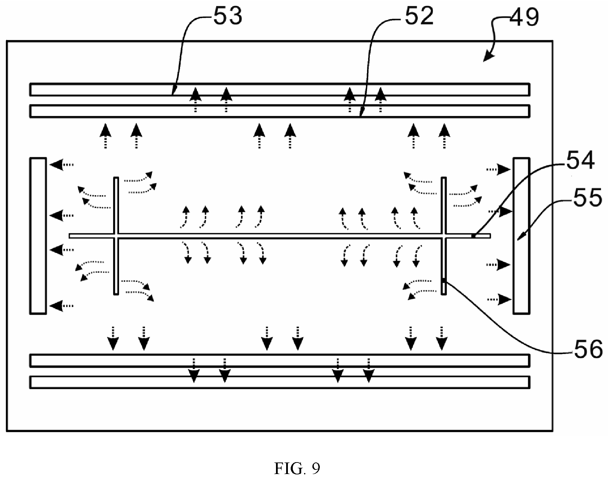

FIG. 9 is a schematic diagram of air flow directions in an embodiment of the present invention.

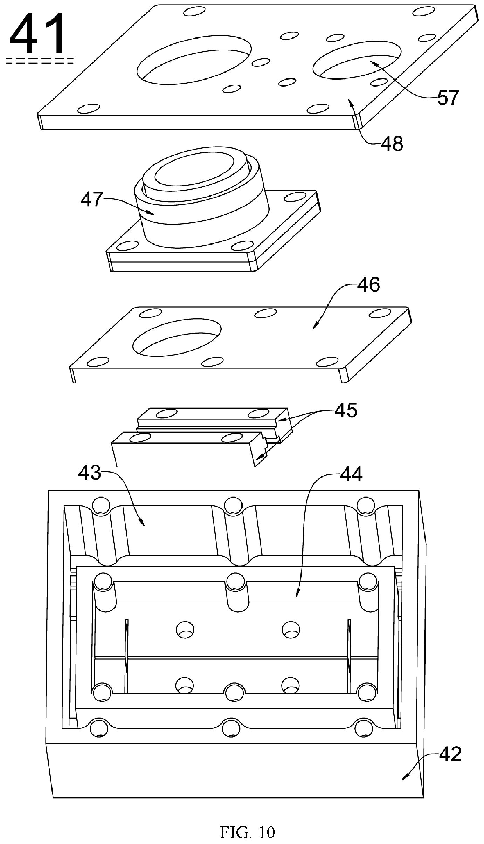

FIG. 10 is a schematic assembly diagram of a dust removal mechanism part in an embodiment of the present invention.

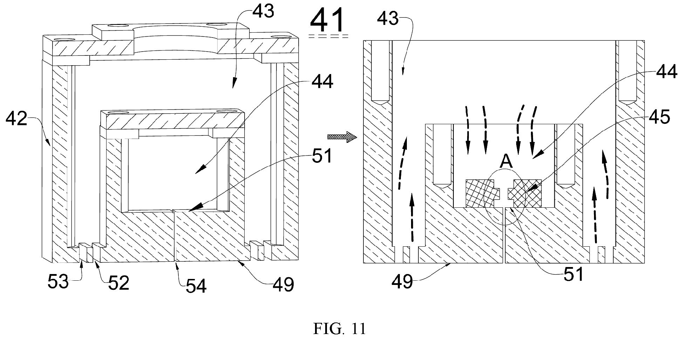

FIG. 11 is a cross-sectional schematic diagram of a dust removal mechanism part in an embodiment of the present invention.

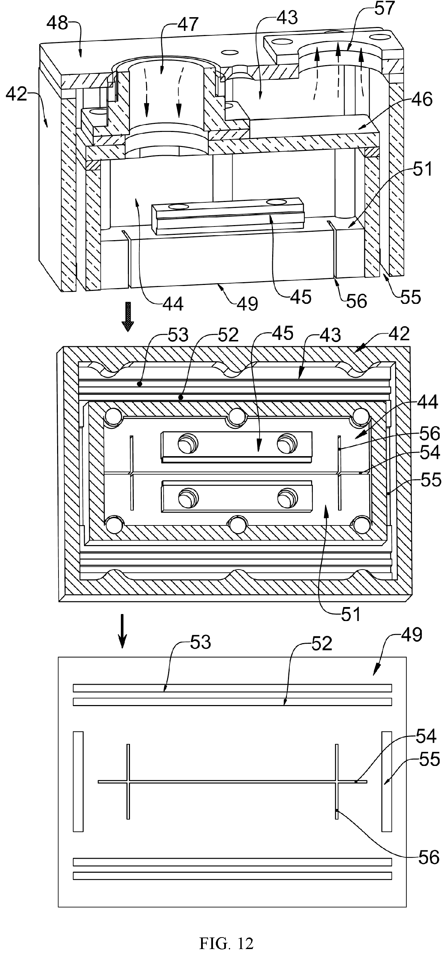

FIG. 12 is a schematic structural diagram of a dust removal mechanism part in an embodiment of the present invention.

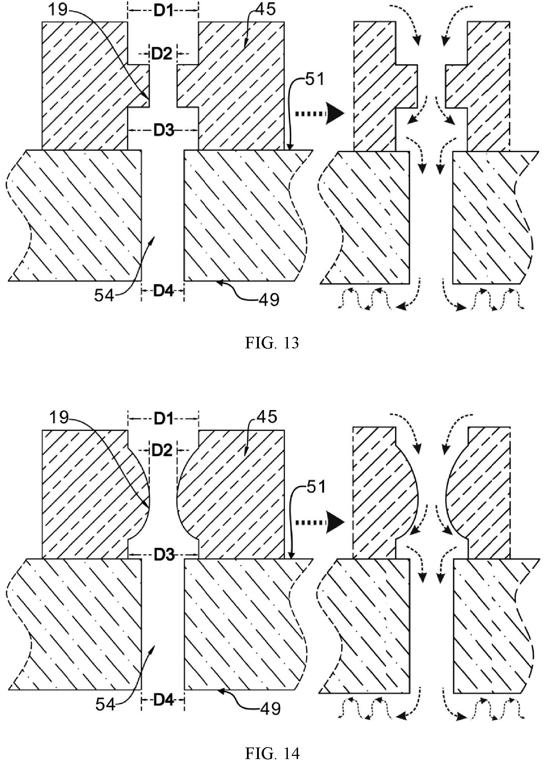

FIG. 13 is a schematic structural diagram of an embodiment of part A in FIG. 11.
FIG. 14 is a schematic structural diagram of another embodiment of part A in FIG. 11.

### DETAILED DESCRIPTION OF THE INVENTION

To further understand the features and technical means of the present invention, and specific objectives and functions achieved by the present invention, the present invention will be described in further detail below with reference to the accompanying drawings and specific embodiments.

Referring to the accompanying drawings, the cleaning device of the present application includes a bottom frame 11. Upright columns 12 extending vertically upwards are provided at four corners of the bottom frame 11. An upper frame 13 is provided at one end of the upright columns 12 away from the bottom frame 11. The bottom frame 11, the upright columns 12 and the upper frame 13 form a mounting frame. A mounting plate 14 is provided in the mounting frame. The mounting plate 14 is arranged at the middle part of the mounting frame. One end of the mounting plate 14 is fixedly arranged at the middle parts of two adjacent upright columns 12, and the other end of the mounting plate 14 away from the upright columns 12 is connected to the upper frame 13 by means of a vertical plate. A vertical frame 16 is arranged between one end of the mounting plate 14 close to the upright columns 12 and the bottom frame 11, and a support crossbeam 15 is arranged between the two upright columns 12 away from the mounting plate 14. The bottom frame 11 is placed on a carrier 81.

A moving mechanism 21 is mounted on the mounting plate 14. A dust removal mechanism 41 is arranged below the moving mechanism 21, and an air pressure assembly 61 is arranged above the moving mechanism 21. The dust removal mechanism 41 is connected to the air pressure assembly 61 by means of a duct 59. The dust removal mechanism 41, the moving mechanism 21 and the air pressure assembly 61 are arranged in the mounting frame.

The dust removal mechanism 41 includes a dust removal head box 42, which also serves as a pressure-dividing chamber. A bottom plate 49 is arranged at the bottom of the dust removal head box 42, and the dust removal head box 42 and the bottom plate 49 are integrally formed. A box sealing cover 48 is arranged at the top end of the dust removal head box 42.

Further, in one of the embodiments, an opening is arranged at the top of the dust removal head box 42, and a box sealing cover 48 is arranged at the opening of the top end of the dust removal head box 42. That is, the box sealing cover 48 serves as a sealing cover plate of the dust removal head box 42. A positive pressure box 44 extending upward from the bottom plate 49 is arranged inside the dust removal head box 42, equivalent to that a frame-shaped positive pressure box 44 is arranged inside the dust removal head box 42. A separation distance is provided between a top end of the positive pressure box 44 and a top end of the dust removal head box 42, equivalent to that between the top end of the positive pressure box 44 away from the bottom plate 49 and the box sealing cover 48, a clearance distance is provided for separating the top end of the positive pressure box 44 from the box sealing cover 48. Further, a height ratio of the positive pressure box 44 to the dust removal head box 42 is 2/3-3/4:1.

Further, in one of the embodiments, a positive pressure sealing cover 46 (a positive pressure cavity cover plate) is arranged at the end of the positive pressure box 44 away from the bottom plate 49. An air intake cylinder 47 extending upward and penetrating the box sealing cover 48 is arranged on the positive pressure sealing cover 46. An end of the air intake cylinder 47 away from the positive pressure box 44 protrudes above the box sealing cover 48, and an upper end of the air intake cylinder 47 is connected to a duct 59. The air intake cylinder 47 is in through connection with the positive pressure box 44.

A separation spacing is provided between an outer wall of the positive pressure box 44 and an inner wall of the dust removal head box 42. A cavity between the inner wall of the dust removal head box 42 and the outer wall of the positive pressure box 44 forms a negative pressure cavity 43, equivalent to that a negative pressure cavity 43 is arranged outside the positive pressure box 44. The annular negative pressure cavity 43 is arranged in the dust removal head box 42. An air suction port 57 is provided on the box sealing cover 48 and is in through connection with the negative pressure cavity 43. The positive pressure box 44 and the negative pressure cavity 43 are respectively arranged in the dust removal head box 42, and are isolated from each other and not connected with each other.

The box sealing cover 48 is connected to the moving mechanism 21 by means of a second hanging slide carriage 34.

Further, in one of the embodiments, a first dust blowing slot 54 transversely penetrating the bottom plate 49 is arranged at the bottom of the positive pressure box 44. Matching and symmetrical second dust blowing slots 56 are arranged at ends of the bottom of the positive pressure box 44 close to two ends of the first dust blowing slot 54. A side blowing distance (a clearance distance is reserved) is provided between each second dust blowing slot 56 and the top end of the first dust blowing slot 54. The second dust blowing slots 56 (side dust blowing slots) and the first dust blowing slot 54 (central dust blowing slot) are arranged vertically and in communication with each other. The first dust blowing slot 54 and the second dust blowing slots 56 are arranged on the bottom plate 49 of the positive pressure box 44 and penetrate the bottom plate 49. That is, the first dust blowing slot 54 and the second dust blowing slots 56 are arranged on the bottom plate 49 and penetrate the bottom plate 49, and the second dust blowing slots 56 are arranged close to the inner walls of the positive pressure box 44 on two short sides. The second dust blowing slots 56 should not be too close to the edges. A clearance distance for blowing and suction operations is reserved between each second dust blowing slot 56 and a corresponding third suction slot 55, so that the second dust blowing slots 56 can blow sideways and outward, and the third suction slots 55 can completely suck the dust away, thereby preventing air leakage and dust escape.

Further, in one of the embodiments, two matching and corresponding variable-section rods 45 are arranged on a positive pressure cavity bottom 51 of the positive pressure box 44, the variable-section rods 45 are arranged parallel to the first dust blowing slot 54, and the two variable-section rods 45 are arranged on two sides of the first dust blowing slot 54 respectively.

The variable-section rods 45 are provided with compressed airflow convex bosses 19 protruding inward (toward each other and facing each other). An air intake distance D1 is provided between the tops of the two matching and corresponding variable-section rods 45, a convex boss distance D2 is provided between the compressed airflow convex bosses 19 on two opposite sides of the middle parts of the two variable-section rods 45, and the air intake distance D1 is greater than the convex boss distance D2. An air output distance D3 is provided between the bottoms of the two matching and corresponding variable-section rods 45, and the first dust blowing slot 54 arranged on the positive pressure cavity bottom 51 is provided with a dust blowing distance D4 which is also the width of the first dust blowing slot 54; the air intake distance D1 is equal to the air output distance D3, and the air output distance D3 is greater than the dust blowing distance D4.

The compressed airflow convex bosses 19 are each in the shape of a convex strip; or the compressed airflow convex bosses 19 are elongated strips with an arc-shaped cross-section; or the compressed airflow convex bosses 19 are elongated strips with a short chord-shaped cross-section.

Variable-section rod 45: Compressed air passes through a variable-section air flow passage. A fluctuating air flow is generated by repeated compression and diffusion as the compressed air passes through the flow passage with a variable section width, and a high-frequency and high-speed pulsed air flow is generated at the outlet position (first dust blowing slot 54), so that ultrafine particles are separated from a substrate, and then are sucked away and collected by the surrounding negative pressure air flow.

The ratio of the air intake distance D1 to the convex boss distance D2 is 5-10:1.

The air intake distance D1 is equal to the air output distance D3 (D1=D3).

The ratio of the dust blowing distance D4 to the convex boss distance D2 is 1:1-1.5.

The air gap size satisfies the relation of D1 = D3 > D2 ≧ D4. The air flow passes through D1→D2→D3→D4 and fluctuates in the air flow passage with a width change pattern of wide→narrow→wide→narrow, thus forming a high-frequency and high-speed pulsed air flow which performs dust blowing and air sweeping at the air outlet of the first dust blowing slot 54.

First suction slots 52 and second suction slots 53, which transversely penetrate the bottom plate 49, are arranged at the bottom of the negative pressure cavity 43, and the first suction slots 52 and the second suction slots 53 are arranged parallel to the first dust blowing slot 54. The first suction slots 52 (inner suction slots) are arranged close to the first dust blowing slot 54, the second suction slots 53 (outer suction slots) are arranged away from the first dust blowing slot 54, and a separation distance is provided between each first suction slot 52 and a corresponding second suction slot 53. Further, the first suction slots 52 and the second suction slots 53 are transversely arranged on the bottom plate 49 of the negative pressure cavity 43 and penetrate the bottom plate 49. That is, the first suction slots 52 and the second suction slots 53 are transversely arranged in parallel on the bottom plate 49 and penetrate the bottom plate 49, and a separation distance is provided between the first dust blowing slot 54 and each first suction slot 52.

Third suction slots 55 longitudinally penetrating the bottom plate 49 are arranged at the bottom of the negative pressure cavity 43 on the two short sides. The third suction slots 55 are arranged between outer walls of the positive pressure box 44 on two short sides and an inner wall of the dust removal head box 42, and the third suction slots 55 are arranged parallel to the second dust blowing slots 56. Further, the third suction slots 55 (side suction slots) extend downward and penetrate the bottom plate 49, and are in through connection with the negative pressure cavity 43.

Further, in one of the embodiments, a width ratio of the first dust blowing slot 54 to the first suction slot 52 to the second suction slot 53 is 1:4-5:4-5;
a width ratio of the second dust blowing slot 56 to the third suction slot 55 is 1:4-5;
the first dust blowing slot 54 and the second dust blowing slots 56 have the same width; the first suction slots 52, the second suction slots 53 and the third suction slots 55 have the same width.

Further, in one of the embodiments, an air volume ratio of the first dust blowing slot 54 to the first suction slot 52 is 1:1.5-3; the air volume of the second suction slot 53 is equal to that of the first suction slot 31;
an air volume ratio of the second dust blowing slot 56 to the third suction slot 55 is 1:1.5-3.

Further, in one of the embodiments, a battery 58 is arranged on the mounting plate 14, and the battery 58 supplies power to all the power components. The moving mechanism 21 includes a first mounting slide rail 28 and a first rack seat 27. The first rack seat 27 and the first mounting slide rail 28 are fixedly arranged below the mounting plate 14, and the first mounting slide rail 28 and the first rack seat 27 are arranged on a side of the mounting plate 14 away from the upright posts 12. The first rack seat 27 and the first mounting slide rail 28 are arranged parallel to the mounting plate 14. A slidable first hanging slide carriage 29 is hung on the first mounting slide rail 28, a first motor 23 is fixedly arranged on the first hanging slide carriage 29, and the first motor 23 is in meshing transmission connection with the first rack seat 27. Specifically, a gear on an output shaft of the first motor 23 is in meshing transmission connection with the first rack seat 27.

The first motor 23 drives the first hanging slide carriage 29 to move back and forth on the first mounting slide rail 28. The first motor 23 drives the first hanging slide carriage 29 to move on the first rack seat 27 by meshing of the gear on the output shaft.

Further, in one of the embodiments, an air pressure assembly base 22 is arranged below the first hanging slide carriage 29 and is fixedly connected to the first hanging slide carriage 29. The air pressure assembly base 22 is arranged perpendicular to the first mounting slide rail 28, with one end of the air pressure assembly base 22 extending out of the mounting plate 14. A bearing wheel 25 is arranged at an end of the air pressure assembly base 22 away from the mounting plate 14, and the bearing wheel 25 is arranged on the support crossbeam 15 which is arranged between two adjacent upright columns 12. A second mounting slide rail 33 and a second rack seat 26, which are parallel to each other, are fixedly arranged on a side of the air pressure assembly base 22 away from the first hanging slide carriage 29, and the second mounting slide rail 33 and second rack seat 26 which are parallel to each other are arranged perpendicular to the first mounting slide rail 28.

Further, in one of the embodiments, a slidable second hanging slide carriage 34 is hung on the second mounting slide rail 33, a second motor 24 is arranged on the second hanging slide carriage 34, and the second motor 24 is in meshing transmission connection with the second rack seat 26. Specifically, a gear on an output shaft of the second motor 24 is in meshing transmission connection with the second rack seat 26.

Further, in one of the embodiments, the dust removal mechanism 41 is hung at an end of the second hanging slide carriage 34 away from the second mounting slide rail 33. The second motor 24 drives the second hanging slide carriage 34 to move back and forth on the second mounting slide rail 33. The second motor 24 drives the second hanging slide carriage 34 to move on the second mounting slide rail 33 by the meshing of the gear on the output shaft. The first motor 23 and the second motor 24 drive the dust removal mechanism 41 to move back and forth, left and right.

The air pressure assembly 61 is arranged on one side of the air pressure assembly base 22 away from the mounting plate 14. The air pressure assembly 61 is arranged outside the mounting plate 14.

Further, in one of the embodiments, the air pressure assembly 61 includes a negative pressure fan 62 and a positive pressure fan 63. A negative pressure high-efficiency filter chamber 66 is arranged above the negative pressure fan 62, and an air suction port of the negative pressure high-efficiency filter chamber 66 extends laterally to the outside of the negative pressure fan 62.

Further, in one of the embodiments, the air suction port of the negative pressure high-efficiency filter chamber 66 is in conductive connection with an air suction port 57 of the dust removal mechanism 41 by means of a duct 59; the positive pressure fan 63 is in conductive connection with the air intake cylinder 47 of the dust removal mechanism 41 by means of another duct 59.

The positive pressure fan 63 has a working pressure of 5 KPa to 12 KPa, and the negative pressure fan 62 has a working pressure of -6 KPa to -1.5 KPa; an air volume ratio of the positive pressure fan 63 to the negative pressure fan 62 is 1:1.5-3. The positive pressure fan 63 and the negative pressure fan 62 are connected to the air intake cylinder 47 and the air suction port 57 of the dust removal mechanism 41 by means of ducts 59. In this way, during dust removal, dust can be better confined and trapped within the clean space around a dust removal head (dust removal mechanism 41), and therefore an air curtain is formed to fully enclose the entire dust removal working space.

A muffler box 65 is arranged on one side of the negative pressure fan 62. Specifically, the negative pressure fan 62 is provided with a lateral air outlet 68, which is connected to the muffler box 65 by means of a duct 59. A square honeycomb cylinder 69 is arranged in the muffler box 65; a plurality of through holes are arranged in a frame square cylinder plate surface of the square honeycomb cylinder 69, and staggered oblique honeycomb baffles 71 on left and right sides are arranged in the square honeycomb cylinder 69.

The oblique honeycomb baffles 71 extend obliquely upward from inner side walls of the square honeycomb cylinder 69. The oblique honeycomb baffles 71 on two sides are arranged one above the other in a staggered manner. The oblique honeycomb baffles 71 on two sides are staggered, and the top ends of the oblique honeycomb baffles 71 on two sides overlap with each other vertically (longitudinally). In this way, an S-shaped air channel is formed inside the square honeycomb cylinder 69, thereby reducing the impact of air turbulence.

The above embodiments only describe several implementations of the invention, and their description is specific and detailed, but cannot therefore be construed as limiting the scope of the invention. It should be noted that those of ordinary skill in the art may further make variations and improvements without departing from the concept of the invention, and these all should fall within the scope of the invention. Therefore, the scope of the present disclosure shall be based on the appended claims.

## Claims

1. A cleaning device for wafer processing, comprising a bottom frame (11), upright columns (12) extending vertically upwards being provided at four corners of the bottom frame (11), an upper frame (13) being provided at one ends of the upright columns (12) away from the bottom frame (11), the bottom frame (11), the upright columns (12) and the upper frame (13) forming a mounting frame, and a mounting plate (14) being provided in the mounting frame,
**characterized in that** a moving mechanism (21) is mounted on the mounting plate (14), a dust removal mechanism (41) is arranged below the moving mechanism (21), and an air pressure assembly (61) is arranged above the moving mechanism (21); the dust removal mechanism (41) is connected to the air pressure assembly (61) by means of a duct (59); the dust removal mechanism (41), the moving mechanism (21) and the air pressure assembly (61) are arranged in the mounting frame;
the dust removal mechanism (41) is connected to the moving mechanism (21) by means of a second hanging slide carriage (34); the dust removal mechanism (41) comprises a dust removal head box (42); a bottom plate (49) is arranged at the bottom of the dust removal head box (42), an opening is arranged at the top of the dust removal head box (42), and a box sealing cover (48) is arranged at the opening at the top end of the dust removal head box (42); a positive pressure box (44) extending upward from the bottom plate (49) is arranged inside the dust removal head box (42), and a separation distance is provided between the top end of the positive pressure box (44) and the top end of the dust removal head box (42);
a separation distance is provided between an outer wall of the positive pressure box (44) and an inner wall of the dust removal head box (42); a negative pressure cavity (43) is arranged outside the positive pressure box (44), and the negative pressure cavity (43) is arranged between the inner wall of the dust removal head box (42) and the outer wall of the positive pressure box (44);
the moving mechanism (21) comprises a first mounting slide rail (28) and a first rack seat (27); the first rack seat (27) and the first mounting slide rail (28) are fixedly arranged under the mounting plate (14), and the first mounting slide rail (28) and the first rack seat (27) are arranged on a side of the mounting plate (14) away from the upright posts (12); the first rack seat (27) and the first mounting slide rail (28) are arranged parallel to the mounting plate (14);
a slidable first hanging slide carriage (29) is hung on the first mounting slide rail (28), a first motor (23) is fixedly arranged on the first hanging slide carriage (29), and the first motor (23) is in meshing transmission connection with the first rack seat (27).

2. The cleaning device for wafer processing according to claim 1, **characterized in that** a positive pressure sealing cover (46) is arranged at an end of the positive pressure box (44) away from the bottom plate (49), an air intake cylinder (47) extending upward and penetrating the box sealing cover (48) is arranged on the positive pressure sealing cover (46), an end of the air intake cylinder (47) away from the positive pressure box (44) protrudes above the box sealing cover (48), an upper end of the air intake cylinder (47) is connected to a duct (59), and the air intake cylinder (47) is in through connection with the positive pressure box (44);
an air suction port (57) is provided on the box sealing cover (48) and is in through connection with the negative pressure cavity (43); the positive pressure box (44) and the negative pressure cavity (43) are respectively arranged in the dust removal head box (42), and are isolated from each other and not connected with each other;
a first dust blowing slot (54) transversely penetrating the bottom plate (49) is arranged at the bottom of the positive pressure box (44); matching and symmetrical second dust blowing slots (56) are arranged at ends of the bottom of the positive pressure box (44) close to two ends of the first dust blowing slot (54); a side blowing distance is provided between each second dust blowing slot (56) and the top end of the first dust blowing slot (54); the second dust blowing slots (56) are arranged perpendicular to the first dust blowing slot (54) and in connection with the first dust blowing slot (54);
a height ratio of the positive pressure box (44) to the dust removal head box (42) is 2/3-3/4: 1.

3. The cleaning device for wafer processing according to claim 1, **characterized in that** an air pressure assembly base (22) is arranged below the first hanging slide carriage (29) and is fixedly connected to the first hanging slide carriage (29); the air pressure assembly base (22) is arranged perpendicular to the first mounting slide rail (28), with one end of the air pressure assembly base (22) extending out of the mounting plate (14); a bearing wheel (25) is arranged at an end of the air pressure assembly base (22) away from the mounting plate (14), and the bearing wheel (25) is arranged on a support crossbeam (15) which is arranged between two adjacent upright columns (12);
a second mounting slide rail (33) and a second rack seat (26), which are parallel to each other, are fixedly arranged on a side of the air pressure assembly base (22) away from the first hanging slide carriage (29), and the second mounting slide rail (33) and second rack seat (26) which are parallel to each other are arranged perpendicular to the first mounting slide rail (28);
a slidable second hanging slide carriage (34) is hung on the second mounting slide rail (33), a second motor (24) is arranged on the second hanging slide carriage (34), and the second motor (24) is in meshing transmission connection with the second rack seat (26);
the air pressure assembly (61) is arranged on one side of the air pressure assembly base (22) away from the mounting plate (14); the air pressure assembly (61) is arranged outside the mounting plate (14);
the air pressure assembly (61) comprises a negative pressure fan (62) and a positive pressure fan (63); a negative pressure high-efficiency filter chamber (66) is arranged above the negative pressure fan (62), and an air suction port of the negative pressure high-efficiency filter chamber (66) extends laterally to the outside of the negative pressure fan (62);
the air suction port of the negative pressure high-efficiency filter chamber (66) is in conductive connection with an air suction port (57) of the dust removal mechanism (41) by means of a duct; the positive pressure fan (63) is in conductive connection with the air intake cylinder (47) of the dust removal mechanism (41) by means of another duct (59).

4. The cleaning device for wafer processing according to claim 3, **characterized in that** a muffler box (65) is arranged on one side of the negative pressure fan (62), and an air outlet of the negative pressure fan (62) is connected to the muffler box (65) by means of a duct (59);
a square honeycomb cylinder (69) is arranged in the muffler box (65); a plurality of through holes are arranged in a frame square cylinder plate surface of the square honeycomb cylinder (69), and staggered oblique honeycomb baffles (71) on left and right sides are arranged in the square honeycomb cylinder (69);
the oblique honeycomb baffles (71) extend obliquely upward from inner side walls of the square honeycomb cylinder (69); the oblique honeycomb baffles (71) on two sides are arranged one above the other in a staggered manner; the oblique honeycomb baffles (71) on two sides are staggered, and the top ends of the oblique honeycomb baffles (71) on two sides overlap with each other vertically; the staggered oblique honeycomb baffles (71) on two sides form an S-shaped air channel inside the square honeycomb cylinder (69);
the negative pressure fan (62) is provided with a lateral air outlet (68), which is connected to the muffler box (65) by means of a duct (59).

5. The cleaning device for wafer processing according to claim 1, **characterized in that** first suction slots (52) and second suction slots (53), which transversely penetrate the bottom plate (49), are arranged at the bottom of the negative pressure cavity (43), and the first suction slots (52) and the second suction slots (53) are arranged parallel to the first dust blowing slot (54); the first suction slots (52) are arranged close to the first dust blowing slot (54), the second suction slots (53) are arranged away from the first dust blowing slot (54), and a separation distance is provided between each first suction slot (52) and a corresponding second suction slot (53);
two matching and corresponding variable-section rods (45) are arranged on a positive pressure cavity bottom (51) of the positive pressure box (44), the variable-section rods (45) are arranged parallel to the first dust blowing slot (54), and the two variable-section rods (45) are arranged on two sides of the first dust blowing slot (54) respectively;
the variable-section rods (45) are provided with compressed airflow convex bosses (19) protruding inward; an air intake distance D1 is provided between the tops of the two matching and corresponding variable-section rods (45), a convex boss distance D2 is provided between the compressed airflow convex bosses (19) on two opposite sides of the middle parts of the two variable-section rods (45), and the air intake distance D1 is greater than the convex boss distance D2; an air output distance D3 is provided between the bottoms of the two matching and corresponding variable-section rods (45), and the first dust blowing slot (54) arranged on the positive pressure cavity bottom (51) is provided with a dust blowing distance D4 which is also the width of the first dust blowing slot (54); the air intake distance D1 is equal to the air output distance D3, and the air output distance D3 is greater than the dust blowing distance D4.

6. The cleaning device for wafer processing according to claim 5, **characterized in that** the compressed airflow convex bosses (19) are each in the shape of a convex strip; or the compressed airflow convex bosses (19) are elongated strips with an arc-shaped cross-section; or the compressed airflow convex bosses (19) are elongated strips with a short chord-shaped cross-section;
a ratio of the air intake distance D1 to the convex boss distance D2 is 5-10:1;
the air intake distance D1 is equal to the air output distance D3; a ratio of the dust blowing distance D4 to the convex boss distance D2 is 1:1-1.5;
third suction slots (55) longitudinally penetrating the bottom plate (49) are arranged at the bottom of the negative pressure cavity (43) on two short sides; the third suction slots (55) are arranged between outer walls of the positive pressure box (44) on two short sides and an inner wall of the dust removal head box (42), and the third suction slots (55) are arranged parallel to the second dust blowing slots (56);
the second dust blowing slots (56) are arranged close to inner walls of the positive pressure box (44) on the two short sides;
a width ratio of the first dust blowing slot (54) to the first suction slot (52) to the second suction slot is 1:4-5:4-5;
a width ratio of the second dust blowing slot (56) to the third suction slot (55) is 1:4-5;
an air volume ratio of the first dust blowing slot (54) to the first suction slot (52) is 1:1.5-3; the air volume of the second suction slot (53) is equal to that of the first suction slot (52);
an air volume ratio of the second dust blowing slot (56) to the third suction slot (55) is 1:1.5-3.

7. The cleaning device for wafer processing according to claim 1, **characterized in that** the mounting plate (14) is arranged at the middle part of the mounting frame; the mounting plate (14) is connected to two adjacent upright columns (12) on one side, and connected to the upper frame (13) on the other side by means of a vertical plate; a vertical frame (16) is arranged between one end of the mounting plate (14) close to the upright columns (12) and the bottom frame (11), and a support crossbeam (15) is arranged between the two upright columns (12) away from the mounting plate (14);
the air pressure assembly (61) is arranged above the moving mechanism (21), the dust removal mechanism (41) is connected to the air pressure assembly (61) by means of a duct (59), and the dust removal mechanism (41), the moving mechanism (21) and the air pressure assembly (61) are arranged in the mounting frame; the box sealing cover (48) is connected to the moving mechanism (21) by means of the second hanging slide carriage (34).

8. The cleaning device for wafer processing according to claim 1, **characterized in that** the mounting plate (14) is arranged at the middle part of the mounting frame; one end of the mounting plate (14) is fixedly arranged at the middle parts of two adjacent upright columns (12), and the other end of the mounting plate (14) away from the upright columns (12) is connected to the upper frame (13) by means of a vertical plate; a vertical frame (16) is arranged between one end of the mounting plate (14) close to the upright columns (12) and the bottom frame (11), and a support crossbeam (15) is arranged between the two upright columns (12) away from the mounting plate;
a gear on an output shaft of the first motor (23) is in meshing transmission connection with the first rack seat (27); a gear on an output shaft of the second motor (24) is in meshing transmission connection with the second rack seat (26);
the dust removal mechanism (41) is hung at an end of the second hanging slide carriage (34) away from the second mounting slide rail (33).
